# EUROPEAN PATENT APPLICATION

(11) **EP 4 797 932 A1**
(43) Date of publication of application: **26.08.2026**
(21) Application number: 26159739.7
(22) Date of filing: 20.02.2026
(51) Int. Cl.: H10W 40/25, C09K 5/10, C09K 5/12

(54) **THREE-DIMENSIONAL (3D) THERMAL JOINTS INCLUDING RHEOLOGY CONTROLLED THERMAL INTERFACE MATERIALS (TIMS)**

(30) Priority: 24.02.2025 US 202563762501 P
(71) Applicant: Laird Technologies, Inc., Chesterfield, MO 63017 (US)
(72) Inventor: STRADER, Jason L., Chesterfield, MO, 63017 (US); HODUL, John N., Chesterfield, MO, 63017 (US)
(74) Representative: Lind Edlund Kenamets Intellectual Property AB

(57) **Abstract**

Disclosed are exemplary methods for forming three-dimensional (3D) thermal joints using thermal interface materials (TIMs), e.g., metal amalgams, low melting alloys, liquid metals, rheology controlled TIMs, *etc.* Also disclosed are exemplary embodiments of three-dimensional (3D) thermal joints including TIMs, e.g., metal amalgams, low melting alloys, liquid metals, rheology controlled TIMs, *etc.* The 3D thermal joint may be used to fill in gap(s) between a heat source(s) and another component(s) of an electronic device. For example, the 3D thermal joint may be used to fill in the gaps between multiple heat sources of varying heights (e.g., integrated circuit (IC) components of varying heights, 2D processor, 2.5D processor, 3D processor, chiplet segmented processor, other component(s) having multiple heights, *etc*.) and a heat removal/dissipation component (e.g., a heat sink, a heat spreader, a heat pipe, a vapor chamber, a water block, a device exterior case, a housing, a chassis, *etc*.).

## Description

### FIELD

The present disclosure generally relates to three-dimensional (3D) thermal joints including thermal interface materials (TIMs), *e.g.,* metal amalgams, low melting alloys, liquid metals, rheology controlled thermal TIMs, *etc.*

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated electronic device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material. The thermal interface material may be used to fill the gap between thermal transfer surfaces, in order to increase thermal transfer efficiency as compared to having the gap filled with air, which is a relatively poor thermal conductor.

### DETAILED DESCRIPTION

Example embodiments will now be described more fully with reference to the accompanying drawings.

As recognized herein, high performance processors may have multiple heights due to their 2D, 2.5D, 3D, chiplet and other designs resulting in multiple different heights for these components making it more difficult to remove heat. After recognizing the above, exemplary embodiments were developed and/or are disclosed herein of methods of forming three-dimensional (3D) thermal joints using rheology controlled thermal interface materials (TIMs), *e.g.,* metal amalgams, low melting alloys (*e.g*., gallium-based liquid metal alloy, low melting alloy having a melting point of 160 °C or less, other low melting alloy, *etc.*), liquid metals (*e.g.,* liquid metal capable of forming a thermal joint at about room temperature, liquid metal capable of forming a thermal joint at a temperature of about 19 °C or less, *etc*.), *etc.*

In exemplary embodiments, a three-dimensional (3D) thermal joint includes a rheology controlled thermal interface material (TIM). The 3D thermal joint may be used to fill in the gap(s) between a heat source(s) and another component(s) of an electronic device. For example, the 3D thermal joint may be used to fill in the gaps between multiple components/heat sources of varying heights (*e.g*., integrated circuit (IC) components of varying heights, 2D processor, 2.5D processor, 3D processor, chiplet segmented processor, other component(s) having multiple heights, *etc.*) and a heat removal/dissipation component (*e.g.,* a heat sink, a heat spreader, a heat pipe, a vapor chamber, a water block, a device exterior case, a housing, a chassis, *etc.*). In such exemplary embodiments, the 3D thermal joint formed by the rheology controlled thermal interface material is three-dimensionally shaped in that the 3D thermal joint will have multiple different heights or thicknesses as determined by the size of the gaps being filled by the rheology controlled thermal interface material between the heat removal/dissipation component and multiple components/heat sources of varying heights.

In exemplary embodiments, a 3D thermal joint formed or defined by a rheology controlled thermal interface material (*e.g.,* metal amalgam, low melting alloy, liquid metal, *etc.*) is used to fill the gaps between a multi-height integrated circuit (IC) (broadly, heat source or component) and a heat sink (broadly, heat removal dissipation component). The 3D thermal joint establishes or defines an efficient thermal path for conducting heat from the multi-height integrated circuit to the heat sink such that heat is flowable through the thermal joint from the multi-height integrated circuit to the heat sink during operation of the electronic device whereby temperature of the multi-height integrated circuit may be reduced. The rheology controlled thermal interface material may be configured such that the 3D thermal joint defined thereby has a high thermal conductivity of 10 Watts per meter Kelvin (W/mK) or greater and a bond line thickness (BLT) within a range from about 3 microns to about 3 millimeters (mm).

An exemplary method includes applying a rheology controlled thermal interface material (*e.g.,* metal amalgam, low melting alloy, liquid metal, *etc*.) to a heat sink (broadly, heat removal dissipation component), to a multi-height integrated circuit (IC) (broadly, heat source or component), or to both the heat sink and the multi-height integrated circuit. For example, a liquid metal may be applied to the heat sink, to the multi-height integrated circuit (IC) (broadly, heat source or component), or to both the heat sink and the multi-height integrated circuit.

In exemplary embodiments, the rheology controlled thermal interface material comprises a liquid metal that is configured to form the 3D thermal joint at about room temperature (*e.g.,* room temperature about 20 °C to 22 °C, a temperature about 19 °C, *etc.*). In such exemplary embodiments, the liquid metal may be applied to a heat sink (broadly, heat removal dissipation component), to a multi-height integrated circuit (IC) (broadly, heat source or component), or to both the heat sink and the multi-height integrated circuit. The liquid metal advantageously does not require heating to form the 3D thermal joint that fills the gaps between the multi-height integrated circuit and the heat sink. The 3D thermal joint formed by the liquid metal is three-dimensionally shaped in that the 3D thermal joint will have multiple different heights or thicknesses as determined by the size of the gaps being filled by the liquid metal between the heat sink and the IC components having varying heights.

In other exemplary embodiments, the rheology controlled thermal interface material comprises a low melting alloy (*e.g*., gallium-based liquid metal alloy, low melting alloy having a melting point of 160 °C or less, other low melting alloy, *etc*.). In such exemplary embodiments, the low melting alloy may be applied to a heat sink (broadly, heat removal dissipation component), to a multi-height integrated circuit (IC) (broadly, heat source or component), or to both the heat sink and the multi-height integrated circuit. The low melting alloy may then be heating to its melting point (*e.g.,* a melting point of 160 °C or less, *etc*.) such that the molten low melting alloy flows into and fills the gaps between the multi-height integrated circuit and the heat sink. After the molten low melting alloy cools and re-solidifies, the low melting alloy forms a 3D thermal joint that fills the gaps between the multi-height integrated circuit and the heat sink. The 3D thermal joint formed by the low melting alloy is three-dimensionally shaped in that the 3D thermal joint will have multiple different heights or thicknesses as determined by the size of the gaps being filled by the liquid metal between the heat sink and the IC components having varying heights.

In some exemplary embodiments, a heat sink (broadly, heat removal dissipation component) may be preassembled to a multi-height integrated circuit (IC) (broadly, heat source or component) of an electronic device before applying the rheology controlled thermal interface material. In such exemplary embodiments, the rheology controlled thermal interface material (*e.g*., metal amalgam, low melting alloy, liquid metal, *etc*.) is applied (*e.g.,* dispensed, *etc*.) to fill the gaps between the preassembled heat sink and the multi-height integrated circuit. For example, liquid metal may be dispensed to fill the gaps between the preassembled heat sink and the multi-height integrated circuit. Or, for example, molten low melting alloy may be dispensed to fill the gaps between the preassembled heat sink and the multi-height integrated circuit.

In some exemplary embodiments, the rheology controlled thermal interface material may comprise a preform having a preformed shape, pattern, thickness, *etc.* During assembly of a heat sink (broadly, heat removal dissipation component) to a multi-height integrated circuit (IC) (broadly, heat source or component) of an electronic device, the preform of the rheology controlled thermal interface material may be positioned or sandwiched between the heat sink the multi-height integrated circuit (IC). The preform of the rheology controlled thermal interface material may then be heated (*e.g.,* to a melting point of 160 °C or less, *etc*.) such that the molten rheology controlled thermal interface material flows into and fills the gaps between the multi-height integrated circuit and the heat sink. After the molten rheology controlled thermal interface material cools and re-solidifies, the rheology controlled thermal interface material fills the gaps between the multi-height integrated circuit and the heat sink. The 3D thermal joint formed by the rheology controlled thermal interface material is three-dimensionally shaped in that the 3D thermal joint will have multiple different heights or thicknesses as determined by the size of the gaps being filled by the rheology controlled thermal interface material between the heat sink and the IC components having varying heights.

By way of example only, exemplary embodiments disclosed herein may include a rheology controlled thermal interface material comprising a metal amalgam including non-refractory filler particles (*e.g.,* non-refractory metal filler particles, *etc*.) as disclosed in U.S. Patent Application Publication No. US2025/0257432, which published August 14, 2025 and is incorporated herein by reference in its entirety. But the metal amalgams including non-refractory filler particles disclosed in U.S. Patent Application Publication No. US2025/0257432 are examples only as other exemplary embodiments include other rheology controlled thermal interface materials besides metal amalgams including non-refractory filler particles and other methods for rheologically controlling a thermal interface material besides the use of non-refractory filler particles. Accordingly, aspects of the present disclosure should not be limited to only metal amalgams including non-refractory filler particles.

In exemplary embodiments, a 3D thermal joint is formed by using a rheology controlled thermal interface material (TIM) that includes non-refractory (not corrosive resistant) metal fillers incorporated into the TIM (*e.g.,* metal amalgam, liquid metal, low melting alloy, *etc*.) such that a stable suspension is obtained and with viscosity control based on the total loading of filler without sacrificing thermal performance for a TIM application. In such exemplary embodiments, the rheology controlled TIM will remain in place (*e.g.,* not migrate, bleed, pump out, or creep out, *etc.*) during thermal reliability testing, *e.g.,* vertical reliability test in thermal shock from -40 °C to 150 °C for 1000 cycles, *etc.* And the rheology controlled TIM can be processed onto a substrate in a controlled manner due to the rheology control allowing for isotropic spreading of the TIM when pressed between thermal transfer surfaces or substrates, *e.g.,* compressed between heat source(s) and heat removal/dissipation component(s) of an electronic device, *etc.* The isotropic spread control (*e.g.,* limited, reduced, or no material migration, *etc*.) occurs when the rheology controlled TIM is pressed between thermal transfer surfaces or substrates, which is a processing advantage in the TIM field as materials will be sandwiched in application and surface coverage of the TIM is important. Conventional liquid metal spreading anisotropic makes it difficult to process.

In exemplary embodiments, a 3D thermal joint is formed by using a rheology controlled thermal interface material (TIM) that comprises a metal alloy (*e.g.,* a low viscosity gallium-indium-tin liquid metal alloy, *etc.*) filled with non-refractory copper and nickel particles, which allows for a stable homogeneous suspension resulting in an increase in viscosity, rheology control based on total loading of filler, robust wetting of various surfaces, and spreading control in processing and reliability. While these properties are enhanced, there is no sacrifice in the thermal performance of the rheology controlled TIM after the copper and nickel particles are mixed into the metal alloy. By way of example only, the rheology controlled thermal TIM may be filled or loaded with about 1 weight percent (wt%) to about 10 wt% (*e.g.,* about 6 wt%, *etc*.) of nickel and copper, such that the rheology controlled TIM had an enhanced or increased viscosity (*e.g*., a custard-like consistency, *etc*.). By way of further example only, the rheology controlled thermal TIM had a thermal conductivity within a range from 28 W/mK to 30 W/mK when the rheology controlled thermal TIM included about 6 wt% of nickel and copper.

In exemplary embodiments, a 3D thermal joint is formed by using a rheology controlled thermal interface material (TIM) that comprises a metal amalgam including nickel and copper such that the ratio of the nickel to the copper by weight percent (wt%) is within a range from about 1:1 to about 5:1. For example, about a 2:1 nickel to copper ratio may be maintained in exemplary embodiments, which achieves a stable homogenous metal amalgam suspension. In exemplary embodiments, the metal amalgam is loaded or filled with the nickel and copper such that the total loading range of the nickel and copper is from about 1 wt% to about 10 wt% (*e.g*., 4 wt%, 6 wt%, 8 wt%, *etc*.). In such exemplary embodiments, the filled metal amalgam may have a thermal conductivity greater than 15 W/mK (*e.g.,* 28 W/mK to 30 W/mK, *etc*.), a thermal resistance less than about 4 mm²K/W but not lower than about 1 mm²K/W, and a viscosity no greater than 2800 pascal-second at 0.5/s shear rate and no greater than 75 pascal-second at 5/s shear rate.

By way of example only, one exemplary embodiment includes a 3D thermal joint formed by using a filled metal amalgam comprising gallium-indium-tin liquid metal alloy filled or loaded with about 6 weight percent (wt%) of nickel and copper. In this example, the filled metal amalgam had a thermal conductivity within a range from about 28 W/mK to about 30 W/mK, a contact thermal resistance of less than about 4 mm²K/W, a viscosity (in air) strain rate 5/s within a range from about 28 to about 33 pascal-second, and a viscosity (in air) strain rate 0.5/s of about 407 pascal-second. From a consistency observational comparison, the filled metal amalgam had a custard-like appearance. The specific alloy, 6 wt% loading, thermal conductivity, thermal resistance, and viscosity provided in this paragraph and elsewhere are examples only as other exemplary embodiments may be configured differently, *e.g.,* different metal alloys (*e.g.,* another low melting alloy having a melting point of 160 °C or less, *etc*.), different liquid metals, higher or lower wt% loading, higher or lower thermal conductivity, higher or lower thermal resistance, and/or higher or lower viscosity, *etc.*

By way of another example only, another exemplary embodiment includes a 3D thermal joint formed by using a filled metal amalgam comprising gallium-indium-tin liquid metal alloy filled or loaded with about 8 weight percent (wt%) of nickel and copper. In this example, the filled metal amalgam had a thermal conductivity within a range from about 28 W/mK to about 30 W/mK, a contact thermal resistance of less than about 4 mm²K/W, a viscosity (in air) strain rate 5/s within a range from about 60 to about 65 pascal-second, and a viscosity (in air) strain rate 0.5/s of about 1997 pascal-second. From a consistency observational comparison, the filled metal amalgam had a consistency of a spreadable paste. The specific alloy, 8 wt% loading, thermal conductivity, thermal resistance, and viscosity provided in this paragraph and elsewhere are examples only as other exemplary embodiments may be configured differently, *e.g.,* different metal alloys (*e.g.,* another low melting alloy having a melting point of 160 °C or less, *etc.*)*,* different liquid metals, higher or lower wt% loading, higher or lower thermal conductivity, higher or lower thermal resistance, and/or higher or lower viscosity, *etc.*

By way of further example only, a further exemplary embodiment includes a 3D thermal joint formed by using a filled metal amalgam comprising gallium-indium-tin liquid metal alloy filled or loaded with about 10 weight percent (wt%) of nickel and copper. In this example, the filled metal amalgam had a thermal conductivity within a range from about 28 W/mK to about 30 W/mK, a contact thermal resistance of less than about 4 mm²K/W, a viscosity (in air) strain rate 5/s within a range from about 60 to about 65 pascal-second, and a viscosity (in air) strain rate 0.5/s of about 2595 pascal-second. From a consistency observational comparison, the filled metal amalgam had a consistency of a spreadable thick paste. The specific alloy, 10 wt% loading, thermal conductivity, thermal resistance, and viscosity provided in this paragraph and elsewhere are examples only as other exemplary embodiments may be configured differently, *e.g.,* different metal alloys (*e.g.,* another low melting alloy having a melting point of 160 °C or less, *etc*.), different liquid metals, higher or lower wt% loading, higher or lower thermal conductivity, higher or lower thermal resistance, and/or higher or lower viscosity, *etc.*

As shown by the above examples, the final consistency of the rheology controlled TIM comprising a metal amalgam loaded with non-refractory filler particles is based on total loading of metal fillers. In exemplary embodiments, the ratio of the nickel to the copper by weight percent (wt%) is within a range from about 1:1 to about 5:1. For example, about a 2:1 nickel to copper ratio may be maintained in the filled metal amalgam, which achieves a stable homogenous metal amalgam suspension. Even though the consistency of the metal amalgam changes depending on the metal filler loading, the thermal performance remains substantially the same, *e.g.,* thermal conductivity greater than 15 W/mK (*e.g.,* within a range from about 28 W/mK to about 30 W/mK, *etc.*) and a thermal resistance of less than about 4 mm²K/W but not lower than about 1 mm²K/W. The above examples show an example range of compositions in which enhanced effect was observed due to the presence of the non-refractory fillers (nickel and copper). These example compositions though observing an increased viscosity and enhanced spread control (*e.g.*, limited, reduced, or no material migration, *etc.*) when pressed between two thermal transfer surfaces or substrates do not observe a change in thermal properties. This is a benefit in the field as other rheology controlled liquid metal included systems sacrifice thermal performance as the rheology and spreading properties are controlled.

Accordingly, exemplary embodiments disclosed herein may provide one or more (but not necessarily any or all) of the following advantages. For example, conventional polymer composite based TIMs are limited as to how thin the bondline can be based on the particles used to enhance the thermal conductivity. Conventionally, the particles are greater than 10 microns or even larger to have high thermal conductivity. For example, particles greater than 25 microns are needed in order for a composite based TIM to achieve a thermal conductivity of 10 W/mK, but particles greater than 25 microns results in a minimum bond line of 25 microns or greater. Advantageously, exemplary embodiments disclosed herein include rheology controlled TIMs that are able to achieve a bondline thickness of 3 microns or less while still having a thermal conductivity of 10 W/mK or greater. By comparison to conventional other liquid metals, the rheology controlled liquid metals used to form 3D thermal joints in exemplary embodiments disclosed herein are able to hold a three-dimensional shape with a maximum thickness of up to about 3 mm without the rheology controlled liquid metal falling out of the thermal joint. In contrast, a conventional non-rheology controlled liquid metal would self-level and migrate out of the thermal joint.

Exemplary embodiments disclosed herein advantageously include rheology controlled TIMs (*e.g.,* metal amalgams, low melting alloys, liquid metals, *etc.*) that do not require a sacrifice in thermal conductivity and thermal resistance in order to maintain rheology and spreading control (*e.g.,* limiting or preventing material migration, *etc.*)*.* Exemplary embodiments disclosed herein do not require any solder preform or surface treatments to keep the TIM in place and/or to wet the surface, as the rheology controlled TIM (*e.g*., metal amalgam, liquid metal, low melting alloy, *etc*.) is capable of wetting surfaces as is. In exemplary embodiments, the rheology controlled TIMs do not contain any organic solvents and/or compounds which could reduce wetting and/or lead to voiding from out-gassing during thermal cycling. For conventional filled liquid metal all metal amalgam systems, maintaining stable suspensions of particles in liquid metal is a key challenge. In exemplary embodiments disclosed herein, the rheology controlled TIM remains a stable suspension after mixing particles into the TIM (*e.g*., metal amalgam, liquid metal, low melting alloy, *etc*.).

Disclosed are exemplary methods that comprise using a rheology controlled thermal interface material to form a three-dimensional thermal joint filling multiple gaps of different distances between first and second thermal transfer surfaces of an electronic device such that heat is flowable through the three-dimensional thermal joint between the first and second thermal transfer surfaces.

In exemplary embodiments, the three-dimensional thermal joint formed by the rheology controlled thermal interface material is three-dimensionally shaped with multiple different heights as determined by the multiple gaps being filled by the rheology controlled thermal interface material between the first and second thermal transfer surfaces of the electronic device.

In exemplary embodiments, the first and/or second thermal transfer surfaces are defined by one or more of: a heat removal/dissipation structure, a heat source of an electronic device, a component of a solid-state drive, and/or a board level shield.

In exemplary embodiments, the first thermal transfer surface is defined by a heat removal/dissipation component(s), such as a heat sink, a heat spreader, a heat pipe, a vapor chamber, a water block, a device exterior case, a housing, a chassis, *etc.* And the second thermal transfer surface is defined by a heat source(s) of an electronic device such as an integrated circuit (*e.g.,* multi-height integrated circuit, *etc*.) or other component of the electronic device.

In exemplary embodiments, the first thermal transfer surface is defined by a heat removal/dissipation component. The second thermal transfer surface is defined by a multi-height heat source. And the three-dimensional thermal joint formed by the rheology controlled thermal interface material is three-dimensionally shaped with multiple different heights as determined by the multiple gaps being filled by the rheology controlled thermal interface material between the heat removal/dissipation component and the multi-height heat source. Heat is flowable through the three-dimensional thermal joint from the multi-height heat source to the heat removal/dissipation component during operation of the electronic device whereby temperature of the multi-height heat source is reduced. In such exemplary embodiments, the heat removal/dissipation component may comprise a heat sink, a heat spreader, a heat pipe, a vapor chamber, a water block, a device exterior case, a housing, a chassis, *etc.* And the multi-height heat source may comprise a multi-height integrated circuit, a 2D processor, 2.5D processor, 3D processor, chiplet segmented processor, *etc.*

In exemplary embodiments, the first thermal transfer surface is defined by a heat sink. The second thermal transfer surface is defined by a multi-height integrated circuit. And the three-dimensional thermal joint formed by the rheology controlled thermal interface material is three-dimensionally shaped with multiple different heights as determined by the multiple gaps being filled by the rheology controlled thermal interface material between the heat sink and the multi-height integrated circuit. Heat is flowable through the three-dimensional thermal joint from the multi-height integrated circuit to the heat sink during operation of the electronic device whereby temperature of the multi-height integrated circuit is reduced. The multi-height integrated circuit may comprise a 2D processor, 2.5D processor, 3D processor, chiplet segmented processor,

*etc.*

In exemplary embodiments, the first thermal transfer surface is defined by a first component of the electronic device. The second thermal transfer surface is defined by a second component of the electronic device. And the method includes: applying the rheology controlled thermal interface material onto the first and/or second thermal transfer surfaces of the electronic device; and thereafter, assembling the first component to the second component.

In exemplary embodiments, the first thermal transfer surface is defined by a first component of the electronic device. The second thermal transfer surface is defined by a second component of the electronic device. And the method includes: assembling the first component to the second component; and thereafter applying the rheology controlled thermal interface material to fill the multiple gaps of different distances between the first and second thermal transfer surfaces of the electronic device.

In exemplary embodiments, the rheology controlled thermal interface material comprises a preform. And the method includes: positioning the preform of the rheology controlled thermal interface material between the first and second thermal transfer surfaces; heating the preform of the rheology controlled thermal interface material such that molten rheology controlled thermal interface material flows into and fills the multiple gaps of different distances between the first and second thermal transfer surfaces; and allowing the molten rheology controlled thermal interface material to cool and re-solidify, to thereby form the three-dimensional thermal joint filling the multiple gaps of different distances between the first and second thermal transfer surfaces of the electronic device.

In exemplary embodiments, the rheology controlled thermal interface material comprises a liquid metal. And the method includes: applying the liquid metal to the first and/or second thermal transfer surface; allowing the liquid metal to flow into and fill the multiple gaps of different distances between the first and second thermal transfer surfaces; and allowing the liquid metal to solidify to thereby form the three-dimensional thermal joint filling the multiple gaps of different distances between the first and second thermal transfer surfaces of the electronic device. In such exemplary methods, the step or process of allowing the liquid metal to solidify may comprise allowing the liquid metal to solidify at about room temperature. Accordingly, the liquid metal does not require heating to form the three-dimensional thermal joint that fills the multiple gaps of different distances between the first and second thermal transfer surfaces of the electronic device.

In exemplary embodiments, the rheology controlled thermal interface material comprises a metal alloy. And the method includes: applying the metal alloy to the first and/or second thermal transfer surface; heating the metal alloy such that molten metal alloy flows into and fills the multiple gaps of different distances between the first and second thermal transfer surfaces; and allowing the molten metal alloy to cool and re-solidify to thereby form the three-dimensional thermal joint filling the multiple gaps of different distances between the first and second thermal transfer surfaces of the electronic device. In such exemplary methods, the low melting alloy may comprise a gallium-based liquid metal alloy and/or the low melting alloy may have a melting point of about 160 °C or less.

In exemplary embodiments, the rheology controlled thermal interface material comprises a metal amalgam including non-refractory filler particles therein. The non-refractory filler particles may comprise non-refractory (not corrosive resistant) metal filler particles. For example, the non-refractory filler particles may comprise copper and nickel. The metal amalgam may be loaded with about 1 percent to about 10 percent of nickel and copper: at a ratio of the nickel to the copper within a range from about 1:1 to about 5:1 by weight percent (wt%) and/or by volume percent (vol%); or at a ratio of the nickel to the copper about a 2:1 ratio of the nickel to the copper by weight percent (wt%) and/or by volume percent (vol%). The metal amalgam including the nickel and copper therein may have a thermal conductivity greater than 15 W/mK, a thermal resistance less than about 4 mm²K/W but not lower than about 1 mm²K/W, and a viscosity no greater than 2800 pascal-second at 0.5/s shear rate and no greater than 75 pascal-second at 5/s shear rate.

In exemplary embodiments, the rheology controlled thermal interface material comprises a gallium-based liquid metal including copper particles and nickel particles.

In exemplary embodiments, the gallium-based liquid metal comprises a low viscosity gallium-indium-tin liquid metal alloy loaded with copper particles and nickel particles to thereby provide: a stable homogeneous suspension resulting in an increase in viscosity of the low viscosity gallium-indium-tin liquid metal alloy; and/or rheology control based on total filler particle loading, robust wetting of various surfaces, limited or prevented material migration, and spreading control in processing and reliability, and with no sacrifice in the thermal performance after the copper particles and the nickel particles are mixed into the low viscosity gallium-indium-tin liquid metal alloy.

In exemplary embodiments, the rheology controlled thermal interface material does not contain any organic solvents and/or organic compounds, which could otherwise reduce wetting and/or lead to voiding from out-gassing during thermal cycling.

In exemplary embodiments, the rheology controlled thermal interface material does not contain any silicone and/or any polymer components, which could otherwise reduce thermal conductivity.

In exemplary embodiments, the rheology controlled thermal interface material consists of only metals.

In exemplary embodiments, the rheology controlled thermal interface material comprises a gallium-indium-tin liquid metal alloy including copper and nickel such that the gallium-indium-tin liquid metal alloy includes a ratio of the nickel to the copper within a range from about 1:1 to about 5:1 by weight percent (wt%) and/or by volume percent (vol%).

Also disclosed herein are exemplary embodiments of three-dimensional thermal joints formed by a method as disclosed herein.

In exemplary embodiments, the first thermal transfer surface is defined by a heat removal/dissipation component. The second thermal transfer surface is defined by a multi-height heat source. And the three-dimensional thermal joint formed by the rheology controlled thermal interface material is three-dimensionally shaped with multiple different heights as determined by the multiple gaps being filled by the rheology controlled thermal interface material between the heat removal/dissipation component and the multi-height heat source. Heat is flowable through the three-dimensional thermal joint from the multi-height heat source to the heat removal/dissipation component during operation of the electronic device whereby temperature of the multi-height heat source is reduced. In such exemplary embodiments, the heat removal/dissipation component may comprise a heat sink, a heat spreader, a heat pipe, a vapor chamber, a water block, a device exterior case, a housing, a chassis, *etc.* And the multi-height heat source may comprise a multi-height integrated circuit, a 2D processor, 2.5D processor, 3D processor, chiplet segmented processor, *etc.*

In exemplary embodiments, the first thermal transfer surface is defined by a heat sink. The second thermal transfer surface is defined by a multi-height integrated circuit. And the three-dimensional thermal joint formed by the rheology controlled thermal interface material is three-dimensionally shaped with multiple different heights as determined by the multiple gaps being filled by the rheology controlled thermal interface material between the heat sink and the multi-height integrated circuit. Heat is flowable through the three-dimensional thermal joint from the multi-height integrated circuit to the heat sink during operation of the electronic device whereby temperature of the multi-height integrated circuit is reduced. In such exemplary embodiments, the multi-height integrated circuit may comprise a 2D processor, 2.5D processor, 3D processor, chiplet segmented processor, *etc.*

Also disclosed are exemplary embodiments of electronic devices including a three-dimensional thermal joint formed by a method as disclosed herein.

In exemplary embodiments, an electronic device includes a first thermal transfer surface defined by a heat removal/dissipation component, and a second thermal transfer surface defined by a multi-height heat source. A three-dimensional thermal joint is formed by a rheology controlled thermal interface material. The three-dimensional thermal joint is three-dimensionally shaped with multiple different heights as determined by the multiple gaps being filled by the rheology controlled thermal interface material between the heat removal/dissipation component and the multi-height heat source. Heat is flowable through the three-dimensional thermal joint from the multi-height heat source to the heat removal/dissipation component during operation of the electronic device whereby temperature of the multi-height heat source is reduced. In such exemplary embodiments, the heat removal/dissipation component may comprise a heat sink, a heat spreader, a heat pipe, a vapor chamber, a water block, a device exterior case, a housing, a chassis, *etc.* And the multi-height heat source may comprise a multi-height integrated circuit, a 2D processor, 2.5D processor, 3D processor, chiplet segmented processor, *etc.*

In exemplary embodiments, an electronic device includes a first thermal transfer surface defined by a heat sink, and a second thermal transfer surface defined by a multi-height integrated circuit. A three-dimensional thermal joint is formed by a rheology controlled thermal interface material. The three-dimensional thermal joint is three-dimensionally shaped with multiple different heights as determined by the multiple gaps being filled by the rheology controlled thermal interface material between the heat sink and the multi-height integrated circuit. Heat is flowable through the three-dimensional thermal joint from the multi-height integrated circuit to the heat sink during operation of the electronic device whereby temperature of the multi-height integrated circuit is reduced. In such exemplary embodiments, the multi-height integrated circuit may comprise a 2D processor, 2.5D processor, 3D processor, chiplet segmented processor, *etc.*

Various aspects of the invention according to the present disclosure include, but are not limited to, the aspects listed in the following numbered clauses.

Clause 1. A method comprising using a thermal interface material to form a three-dimensional thermal joint filling multiple gaps of different distances between first and second thermal transfer surfaces of an electronic device such that heat is flowable through the three-dimensional thermal joint between the first and second thermal transfer surfaces, whereby the three-dimensional thermal joint formed by the thermal interface material is three-dimensionally shaped with multiple different heights as determined by the multiple gaps being filled by the thermal interface material between the first and second thermal transfer surfaces of the electronic device.

Clause 2. The method of clause 1, wherein: the thermal interface material comprises a rheology controlled thermal interface material; and the method of forming the three-dimensional thermal joint between the first and second thermal transfer surfaces of the electronic device comprises: dispensing the rheology controlled thermal interface material between the first and second thermal transfer surfaces; and allowing the rheology controlled thermal interface material to fill the multiple gaps of different distances between the first and second thermal transfer surfaces so as to form the three dimensionally shaped thermal joint having multiple different heights that correspond to the different distances; whereby the three-dimensional thermal joint provides a continuous thermal path between the first and second thermal transfer surfaces.

Clause 3. The method of clause 1, wherein: the thermal interface material comprises a rheology controlled thermal interface material; and/or the thermal interface material comprises a metal amalgam including non-refractory filler particles therein.

Clause 4. The method of clause 3, wherein the non-refractory filler particles comprise non-refractory (not corrosive resistant) metal filler particles.

Clause 5. The method of clause 3, wherein the non-refractory filler particles comprise copper and nickel, and wherein: the metal amalgam is loaded with about 1 percent to about 10 percent of nickel and copper: at a ratio of the nickel to the copper within a range from about 1:1 to about 5:1 by weight percent (wt%) and/or by volume percent (vol%); or at a ratio of the nickel to the copper about a 2:1 ratio of the nickel to the copper by weight percent (wt%) and/or by volume percent (vol%); and/or the metal amalgam including the nickel and copper therein has a thermal conductivity greater than 15 W/mK, a thermal resistance less than about 4 mm2K/W but not lower than about 1 mm2K/W, and a viscosity no greater than 2800 pascal-second at 0.5/s shear rate and no greater than 75 pascal-second at 5/s shear rate.

Clause 6. The method of clause 1, wherein the thermal interface material comprises a gallium-based liquid metal including copper particles and nickel particles.

Clause 7. The method of clause 6, wherein the gallium-based liquid metal comprises a low viscosity gallium-indium-tin liquid metal alloy loaded with the copper particles and the nickel particles.

Clause 8. The method of clause 1, wherein: the thermal interface material comprises a rheology controlled thermal interface material consisting of only metals; the rheology controlled thermal interface material does not contain any organic solvents or organic compounds, which could otherwise reduce wetting and lead to voiding from out-gassing during thermal cycling; and the rheology controlled thermal interface material does not contain any silicone or any polymer components, which could otherwise reduce thermal conductivity.

Clause 9. The method of clause 1, wherein the thermal interface material comprises a gallium-indium-tin liquid metal alloy including copper and nickel such that the gallium-indium-tin liquid metal alloy includes a ratio of the nickel to the copper within a range from about 1:1 to about 5:1 by weight percent (wt%) and/or by volume percent (vol%).

Clause 10. The method of clause 1, wherein the thermal interface material is a rheology controlled thermal interface material that comprises a metal amalgam, a liquid metal, or a low melting alloy.

Clause 11. The method of clause 1, wherein: the thermal interface material comprises a low melting alloy; the first thermal transfer surface is defined by a first component of the electronic device; the second thermal transfer surface is defined by a second component of the electronic device; and the method includes: assembling the first component to the second component such that the low melting alloy is between the first and second thermal transfer surfaces; heating the low melting alloy to a temperature above a typical operating temperature of the electronic device such that the low melting alloy flows into and fills the multiple gaps of different distances between the first and second thermal transfer surfaces of the electronic device; and allowing the low melting alloy to cool to thereby form the three-dimensional thermal joint filling the multiple gaps of different distances between the first and second thermal transfer surfaces of the electronic device.

Clause 12. The method of clause 11, wherein assembling the first component to the second component includes applying pressure to the low melting alloy between the first and second thermal transfer surfaces, which pressure may be removed or remain during operation of the electronic device.

Clause 13. The method of clause 1, wherein: the thermal interface material comprises a liquid metal; and the method includes: applying the liquid metal to the first and/or second thermal transfer surface; allowing the liquid metal to flow into and fill the multiple gaps of different distances between the first and second thermal transfer surfaces; and allowing the liquid metal to solidify to thereby form the three-dimensional thermal joint filling the multiple gaps of different distances between the first and second thermal transfer surfaces of the electronic device.

Clause 14. The method of clause 13, wherein allowing the liquid metal to solidify comprises allowing the liquid metal to solidify at about room temperature whereby the liquid metal does not require heating to form the three-dimensional thermal joint that fills the multiple gaps of different distances between the first and second thermal transfer surfaces of the electronic device.

Clause 15. The method of clause 1, wherein: the thermal interface material comprises a metal alloy; and the method includes: applying the metal alloy to the first and/or second thermal transfer surface; heating the metal alloy such that molten metal alloy flows into and fills the multiple gaps of different distances between the first and second thermal transfer surfaces; and allowing the molten metal alloy to cool and re-solidify to thereby form the three-dimensional thermal joint filling the multiple gaps of different distances between the first and second thermal transfer surfaces of the electronic device.

Clause 16. The method of clause 15, wherein the metal alloy comprises a gallium-based liquid metal alloy and/or has a melting point of about 160 °C or less.

Clause 17. The method of any one of clauses 1 to 16, wherein: the first thermal transfer surface is defined by a heat removal/dissipation component; the second thermal transfer surface is defined by a multi-height heat source; and the three-dimensional thermal joint formed by the thermal interface material is three-dimensionally shaped with multiple different heights as determined by the multiple gaps being filled by the thermal interface material between the heat removal/dissipation component and the multi-height heat source, whereby heat is flowable through the three-dimensional thermal joint from the multi-height heat source to the heat removal/dissipation component during operation of the electronic device whereby temperature of the multi-height heat source is reduced.

Clause 18. The method of any one of clauses 1 to 16, wherein: the first thermal transfer surface is defined by a heat sink; the second thermal transfer surface is defined by a multi-height integrated circuit; and the three-dimensional thermal joint formed by the thermal interface material is three-dimensionally shaped with multiple different heights as determined by the multiple gaps being filled by the thermal interface material between the heat sink and the multi-height integrated circuit, whereby heat is flowable through the three-dimensional thermal joint from the multi-height integrated circuit to the heat sink during operation of the electronic device whereby temperature of the multi-height integrated circuit is reduced.

Clause 19. The method of clause 18, wherein the multi-height integrated circuit comprises a 2D processor, 2.5D processor, 3D processor, or chiplet segmented processor.

Clause 20. The method of any one of clauses 1 to 10, wherein: the first thermal transfer surface is defined by a first component of the electronic device; the second thermal transfer surface is defined by a second component of the electronic device; and the method includes: applying the thermal interface material onto the first and/or second thermal transfer surfaces of the electronic device, and thereafter assembling the first component to the second component; or assembling the first component to the second component, and thereafter applying the rheology controlled thermal interface material to fill the multiple gaps of different distances between the first and second thermal transfer surfaces of the electronic device.

Clause 21. The method of any one of clauses 1 to 10, wherein: the thermal interface material comprises a preform; and the method includes: positioning the preform of the thermal interface material between the first and second thermal transfer surfaces; heating the preform of the thermal interface material such that molten thermal interface material flows into and fills the multiple gaps of different distances between the first and second thermal transfer surfaces; and allowing the molten thermal interface material to cool and re-solidify, to thereby form the three-dimensional thermal joint filling the multiple gaps of different distances between the first and second thermal transfer surfaces of the electronic device.

Clause 22. The method of any one of clauses 1 to 21, wherein the first and/or second thermal transfer surfaces are defined by one or more of: a heat removal/dissipation structure; a heat source of an electronic device; a component of a solid-state drive; and/or a board level shield.

Clause 23. The method of any one of the clauses 1 to 22, wherein: the first thermal transfer surface is defined by a heat removal/dissipation component(s), such as a heat sink, a heat spreader, a heat pipe, a vapor chamber, a water block, a device exterior case, a housing, or a chassis; and the second thermal transfer surface is defined by a heat source(s) of the electronic device such as an integrated circuit or other component of the electronic device.

Clause 24. The method of any one of the clauses 1 to 23, wherein the thermal interface material exhibits isotropic spread control under compression between the surfaces to limit migration, bleed, pump out, or creep during assembly and thermal cycling.

Clause 25. The method of any one of the clauses 1 to 24, wherein the thermal interface material provides a bond line thickness within about 3 µm to about 3 mm in situ.

Clause 26. The method of any one of the clauses 1 to 25, wherein the thermal interface material has a thermal conductivity of at least 10 W/m·K.

Clause 27. The method of any one of the clauses 1 to 26, wherein the thermal interface material is a liquid metal that forms the thermal joint at about room temperature without external heating.

Clause 28. The method of any one of the clauses 1 to 27, wherein the thermal interface material is a low melting alloy that is heated to a melting point of about 160 °C or less, dispensed or flowed to fill the multiple gaps, and re-solidified to form the three-dimensional thermal joint.

Clause 29. The method of any one of the clauses 1 to 28, wherein the thermal interface material forms the three dimensional shape under gravity in a vertical orientation without self-leveling migration out of the joint.

Clause 30. The method of any one of the clauses 1 to 29, wherein the three-dimensional thermal joint maintains position during a thermal shock cycling test from -40 °C to 150 °C for at least 1000 cycles.

Clause 31. A three-dimensional thermal joint formed by a method according to any one of clauses 1 to 30.

Clause 32. The three-dimensional thermal joint of clause 31, wherein: the first thermal transfer surface is defined by a heat removal/dissipation component; the second thermal transfer surface is defined by a multi-height heat source; and the three-dimensional thermal joint formed by the thermal interface material is three-dimensionally shaped with multiple different heights as determined by the multiple gaps being filled by the thermal interface material between the heat removal/dissipation component and the multi-height heat source, whereby heat is flowable through the three-dimensional thermal joint from the multi-height heat source to the heat removal/dissipation component during operation of the electronic device whereby temperature of the multi-height heat source is reduced.

Clause 33. The three-dimensional thermal joint of clause 31, wherein: the first thermal transfer surface is defined by a heat sink; the second thermal transfer surface is defined by a multi-height integrated circuit; and the three-dimensional thermal joint formed by the thermal interface material is three-dimensionally shaped with multiple different heights as determined by the multiple gaps being filled by the thermal interface material between the heat sink and the multi-height integrated circuit, whereby heat is flowable through the three-dimensional thermal joint from the multi-height integrated circuit to the heat sink during operation of the electronic device whereby temperature of the multi-height integrated circuit is reduced.

Clause 34. The three-dimensional thermal joint of clause 33, wherein the multi-height integrated circuit comprises a 2D processor, a 2.5D processor, a 3D processor, or a chiplet segmented processor.

Clause 35. An electronic device including a three-dimensional thermal joint formed by a method according to any one of clauses 1 to 30.

Clause 36. The electronic device of clause 3, wherein: the first thermal transfer surface is defined by a heat removal/dissipation component; the second thermal transfer surface is defined by a multi-height heat source; and the three-dimensional thermal joint formed by the thermal interface material is three-dimensionally shaped with multiple different heights as determined by the multiple gaps being filled by the thermal interface material between the heat removal/dissipation component and the multi-height heat source, whereby heat is flowable through the three-dimensional thermal joint from the multi-height heat source to the heat removal/dissipation component during operation of the electronic device whereby temperature of the multi-height heat source is reduced.

Clause 37. The electronic device of clause 35, wherein: the first thermal transfer surface is defined by a heat sink; the second thermal transfer surface is defined by a multi-height integrated circuit; and the three-dimensional thermal joint formed by the thermal interface material is three-dimensionally shaped with multiple different heights as determined by the multiple gaps being filled by the thermal interface material between the heat sink and the multi-height integrated circuit, whereby heat is flowable through the three-dimensional thermal joint from the multi-height integrated circuit to the heat sink during operation of the electronic device whereby temperature of the multi-height integrated circuit is reduced.

Clause 38. The electronic device of clause 37, wherein the multi-height integrated circuit comprises a 2D processor, a 2.5D processor, a 3D processor, or a chiplet segmented processor.

Clause 39. A three-dimensional thermal joint comprising a thermal interface material configured for filling multiple gaps of different distances between first and second thermal transfer surfaces of an electronic device such that heat is flowable through the three-dimensional thermal joint between the first and second thermal transfer surfaces, whereby the three-dimensional thermal joint formed by the thermal interface material is three-dimensionally shaped with multiple different heights as determined by the multiple gaps being filled by the thermal interface material between the first and second thermal transfer surfaces of the electronic device.

Clause 40. The three-dimensional thermal joint of clause 39, wherein the thermal interface material is a rheology controlled thermal interface material that comprises a metal amalgam, a liquid metal, or a low melting alloy.

Clause 41. The three-dimensional thermal joint of clause 39, wherein: the thermal interface material comprises a rheology controlled thermal interface material; and/or the thermal interface material comprises a metal amalgam including non-refractory filler particles therein.

Clause 42. The three-dimensional joint of clause 41, wherein the non-refractory filler particles comprise non-refractory (not corrosive resistant) metal filler particles.

Clause 43. The three-dimensional joint of clause 41 or 42, wherein the non-refractory filler particles comprise copper and nickel, and wherein: the metal amalgam is loaded with about 1 percent to about 10 percent of nickel and copper: at a ratio of the nickel to the copper within a range from about 1:1 to about 5:1 by weight percent (wt%) and/or by volume percent (vol%); or at a ratio of the nickel to the copper about a 2:1 ratio of the nickel to the copper by weight percent (wt%) and/or by volume percent (vol%); and/or the metal amalgam including the nickel and copper therein has a thermal conductivity greater than 15 W/mK, a thermal resistance less than about 4 mm2K/W but not lower than about 1 mm2K/W, and a viscosity no greater than 2800 pascal-second at 0.5/s shear rate and no greater than 75 pascal-second at 5/s shear rate.

Clause 44. The three-dimensional joint of any one of clauses 39 to 43, wherein the thermal interface material comprises a gallium-based liquid metal including copper particles and nickel particles.

Clause 45. The three-dimensional joint of clause 44, wherein the gallium-based liquid metal comprises a low viscosity gallium-indium-tin liquid metal alloy loaded with the copper particles and the nickel particles.

Clause 46. The three-dimensional joint of any one of clauses 39 to 45, wherein: the thermal interface material comprises a rheology controlled thermal interface material consisting of only metals; the rheology controlled thermal interface material does not contain any organic solvents or organic compounds, which could otherwise reduce wetting and lead to voiding from out-gassing during thermal cycling; and the rheology controlled thermal interface material does not contain any silicone or any polymer components, which could otherwise reduce thermal conductivity.

Clause 47. The three-dimensional joint of any one of clauses 39 to 46, wherein the thermal interface material comprises a gallium-indium-tin liquid metal alloy including copper and nickel such that the gallium-indium-tin liquid metal alloy includes a ratio of the nickel to the copper within a range from about 1:1 to about 5:1 by weight percent (wt%) and/or by volume percent (vol%).

Clause 48. The three-dimensional joint of any one of clauses 39 to 47, wherein the thermal interface material comprises a gallium-based liquid metal alloy and/or a metal alloy having a melting point of about 160 °C or less.

Clause 49. The three-dimensional thermal joint of any one of clauses 39 to 48, wherein the thermal interface material exhibits stable suspension of metallic filler particles and isotropic spreading control under assembly compression.

Clause 50. The three-dimensional thermal joint of any one of clauses 39 to 49, wherein the three-dimension thermal joint in situ provides a bond line thickness within a range from about 3 µm to about 3 mm and a thermal conductivity of at least 10 W/m·K.

Clause 51. The three-dimensional thermal joint of any one of clauses 39 to 50, wherein maximum joint thickness sustained without loss from the three-dimensional thermal joint is up to about 3 millimeters.

Clause 52. An electronic device including the three-dimensional thermal joint according to any one of clauses 39 to 51.

Clause 53. The electronic device of clause 52, wherein: the first thermal transfer surface is defined by a heat removal/dissipation component; the second thermal transfer surface is defined by a multi-height heat source; and the three-dimensional thermal joint formed by the thermal interface material is three-dimensionally shaped with multiple different heights as determined by the multiple gaps being filled by the thermal interface material between the heat removal/dissipation component and the multi-height heat source, whereby heat is flowable through the three-dimensional thermal joint from the multi-height heat source to the heat removal/dissipation component during operation of the electronic device whereby temperature of the multi-height heat source is reduced.

Clause 54. The electronic device of clause 52, wherein: the first thermal transfer surface is defined by a heat sink; the second thermal transfer surface is defined by a multi-height integrated circuit; and the three-dimensional thermal joint formed by the thermal interface material is three-dimensionally shaped with multiple different heights as determined by the multiple gaps being filled by the rheology controlled thermal interface material between the heat sink and the multi-height integrated circuit, whereby heat is flowable through the three-dimensional thermal joint from the multi-height integrated circuit to the heat sink during operation of the electronic device whereby temperature of the multi-height integrated circuit is reduced.

Clause 55. The electronic device of clause 54, wherein the multi-height integrated circuit comprises a 2D processor, a 2.5D processor, a 3D processor, or a chiplet segmented processor.

Clause 56. A rheology-controlled metallic thermal interface material comprising a gallium-indium-tin liquid metal alloy loaded with copper particles and nickel particles, wherein a nickel-to-copper ratio is about 1:1 to about 5:1 by weight and a total metal filler loading is about 1 wt% to about 10 wt%, the thermal interface material exhibiting: (a) stable homogeneous suspension of the particles; (b) viscosity no greater than 2800 Pa·s at 0.5 s⁻¹ and no greater than 75 Pa·s at 5 s⁻¹; and (c) thermal conductivity greater than 15 W/m·K and contact thermal resistance less than about 4 mm²·K/W.

Clause 57. The thermal interface material of clause 56, wherein the nickel-to-copper ratio is about 2:1 by weight and the total loading is about 6 wt%.

Clause 58. The thermal interface material of clause 56 or 57, having a custard-like consistency at about 6 wt% filler loading or a spreadable paste consistency at about 8-10 wt% filler loading.

Clause 59. The thermal interface material of any one of clauses 56 to 58, consisting only of metals and being free of organic solvents, organic compounds, silicones, and polymeric components.

Clause 60. The thermal interface material of any one of clauses 56 to 59, wherein the gallium based alloy has a melting point of about 160 °C or less.

Example embodiments are provided so that this disclosure will be thorough, and will fully convey the scope to those who are skilled in the art. Numerous specific details are set forth such as examples of specific components, electronic devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known electronic device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that Parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if Parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc*.). As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally," "about," and "substantially," may be used herein to mean within manufacturing tolerances. Or, for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about," the claims include equivalents to the quantities.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath," "below," "lower," "above," "upper" and the like, may be used herein for ease of description to describe one element or feature's relationship to another element(s) or feature(s) as illustrated in the figures. Spatially relative terms may be intended to encompass different orientations of the electronic device in use or operation in addition to the orientation depicted in the figures. For example, if the electronic device in the figures is turned over, elements described as "below" or "beneath" other elements or features would then be oriented "above" the other elements or features. Thus, the example term "below" can encompass both an orientation of above and below. The electronic device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A method comprising using a thermal interface material to form a three-dimensional thermal joint filling multiple gaps of different distances between first and second thermal transfer surfaces of an electronic device such that heat is flowable through the three-dimensional thermal joint between the first and second thermal transfer surfaces, whereby the three-dimensional thermal joint formed by the thermal interface material is three-dimensionally shaped with multiple different heights as determined by the multiple gaps being filled by the thermal interface material between the first and second thermal transfer surfaces of the electronic device.

2. The method of any one of the preceding claims, wherein:
the thermal interface material comprises a rheology controlled thermal interface material; and/or
the thermal interface material comprises a metal amalgam including non-refractory filler particles therein.

3. The method of any one of the preceding claims, wherein:
the thermal interface material comprises a rheology controlled thermal interface material consisting of only metals;
the rheology controlled thermal interface material does not contain any organic solvents or organic compounds, which could otherwise reduce wetting and lead to voiding from out-gassing during thermal cycling; and
the rheology controlled thermal interface material does not contain any silicone or any polymer components, which could otherwise reduce thermal conductivity.

4. The method of any one of the preceding claims, wherein the thermal interface material is a rheology controlled thermal interface material that comprises a metal amalgam, a liquid metal, or a low melting alloy.

5. The method of any one of the preceding claims, wherein the thermal interface material comprises a gallium-indium-tin liquid metal alloy including copper and nickel such that the gallium-indium-tin liquid metal alloy includes a ratio of the nickel to the copper within a range from about 1:1 to about 5:1 by weight percent (wt%) and/or by volume percent (vol%).

6. The method of any one of the preceding claims, wherein:
the thermal interface material comprises a rheology controlled thermal interface material; and
the method of forming the three-dimensional thermal joint between the first and second thermal transfer surfaces of the electronic device comprises:
dispensing the rheology controlled thermal interface material between the first and second thermal transfer surfaces; and
allowing the rheology controlled thermal interface material to fill the multiple gaps of different distances between the first and second thermal transfer surfaces so as to form the three dimensionally shaped thermal joint having multiple different heights that correspond to the different distances;
whereby the three-dimensional thermal joint provides a continuous thermal path between the first and second thermal transfer surfaces.

7. The method of any one of the preceding claims, wherein:
the thermal interface material comprises a low melting alloy;
the first thermal transfer surface is defined by a first component of the electronic device;
the second thermal transfer surface is defined by a second component of the electronic device; and
the method includes:
assembling the first component to the second component such that the low melting alloy is between the first and second thermal transfer surfaces;
heating the low melting alloy to a temperature above a typical operating temperature of the electronic device such that the low melting alloy flows into and fills the multiple gaps of different distances between the first and second thermal transfer surfaces of the electronic device; and
allowing the low melting alloy to cool to thereby form the three-dimensional thermal joint filling the multiple gaps of different distances between the first and second thermal transfer surfaces of the electronic device.

8. The method of any one of claims 1 to 6, wherein:
the thermal interface material comprises a liquid metal; and
the method includes:
applying the liquid metal to the first and/or second thermal transfer surface;
allowing the liquid metal to flow into and fill the multiple gaps of different distances between the first and second thermal transfer surfaces; and
allowing the liquid metal to solidify to thereby form the three-dimensional thermal joint filling the multiple gaps of different distances between the first and second thermal transfer surfaces of the electronic device.

9. The method of claim 8, wherein allowing the liquid metal to solidify comprises allowing the liquid metal to solidify at about room temperature whereby the liquid metal does not require heating to form the three-dimensional thermal joint that fills the multiple gaps of different distances between the first and second thermal transfer surfaces of the electronic device.

10. The method of any one of claims 1 to 6, wherein:
the thermal interface material comprises a metal alloy; and
the method includes:
applying the metal alloy to the first and/or second thermal transfer surface;
heating the metal alloy such that molten metal alloy flows into and fills the multiple gaps of different distances between the first and second thermal transfer surfaces; and
allowing the molten metal alloy to cool and re-solidify to thereby form the three-dimensional thermal joint filling the multiple gaps of different distances between the first and second thermal transfer surfaces of the electronic device.

11. The method of claim 10, wherein the metal alloy comprises a gallium-based liquid metal alloy and/or has a melting point of about 160 °C or less.

12. The method of any one of the preceding claims, wherein:
the first thermal transfer surface is defined by a heat sink;
the second thermal transfer surface is defined by a multi-height integrated circuit; and
the three-dimensional thermal joint formed by the thermal interface material is three-dimensionally shaped with multiple different heights as determined by the multiple gaps being filled by the thermal interface material between the heat sink and the multi-height integrated circuit, whereby heat is flowable through the three-dimensional thermal joint from the multi-height integrated circuit to the heat sink during operation of the electronic device whereby temperature of the multi-height integrated circuit is reduced.

13. A three-dimensional thermal joint comprising a thermal interface material configured for filling multiple gaps of different distances between first and second thermal transfer surfaces of an electronic device such that heat is flowable through the three-dimensional thermal joint between the first and second thermal transfer surfaces, whereby the three-dimensional thermal joint formed by the thermal interface material is three-dimensionally shaped with multiple different heights as determined by the multiple gaps being filled by the thermal interface material between the first and second thermal transfer surfaces of the electronic device.

14. The three-dimensional thermal joint of claim 13, wherein the thermal interface material is a rheology controlled thermal interface material that comprises a metal amalgam, a liquid metal, or a low melting alloy.

15. An electronic device including the three-dimensional thermal joint according to claim 13 or 14, wherein:
the first thermal transfer surface is defined by a heat sink;
the second thermal transfer surface is defined by a multi-height integrated circuit; and
the three-dimensional thermal joint formed by the thermal interface material is three-dimensionally shaped with multiple different heights as determined by the multiple gaps being filled by the rheology controlled thermal interface material between the heat sink and the multi-height integrated circuit, whereby heat is flowable through the three-dimensional thermal joint from the multi-height integrated circuit to the heat sink during operation of the electronic device whereby temperature of the multi-height integrated circuit is reduced.

## Amended claims

### Amended claims in accordance with Rule 137(2) EPC.

1. A method of forming a three-dimensional thermal joint between a first thermal transfer surface and a second thermal transfer surface of an electronic device, comprising:
providing a thermal interface material comprising:
(i) a low melting alloy having a melting point of 160 °C or less; and
(ii) non-refractory metal filler particles comprising copper and nickel;
wherein a total loading range of the filler particles is from about 1 weight percent to about 10 weight percent and a nickel-to-copper ratio is from about 1:1 to about 5:1;
applying the thermal interface material to at least one of the first and second thermal transfer surfaces;
assembling the first and second thermal transfer surfaces;
wherein:
the first thermal transfer surface is defined by a heat sink;
the second thermal transfer surface is defined by a multi-height integrated circuit; and
the three-dimensional thermal joint formed by the thermal interface material is three-dimensionally shaped with multiple different heights as determined by multiple gaps being filled by the thermal interface material between the heat sink and the multi-height integrated circuit, whereby heat is able to flow through the three-dimensional thermal joint from the multi-height integrated circuit to the heat sink during operation of the electronic device whereby temperature of the multi-height integrated circuit is reduced;
wherein the thermal interface material fills multiple gaps of different distances between the first and second thermal transfer surfaces to form the three-dimensional thermal joint having multiple different heights; and
wherein the thermal interface material provides a continuous thermal path between the first and second thermal transfer surfaces.

2. The method of claim 1, wherein the multi-height integrated circuit comprises a 2.5D processor, a 3D processor, or a chiplet segmented processor.

3. The method of any one of the preceding claims, wherein:
the thermal interface material comprises a rheology controlled thermal interface material; and/or
the thermal interface material comprises a metal amalgam including non-refractory filler particles therein.

4. The method of any one of the preceding claims, wherein:
the thermal interface material comprises a rheology controlled thermal interface material consisting of only metals;
the rheology controlled thermal interface material does not contain any organic solvents or organic compounds, which could otherwise reduce wetting and lead to voiding from out-gassing during thermal cycling; and
the rheology controlled thermal interface material does not contain any silicone or any polymer components, which could otherwise reduce thermal conductivity.

5. The method of any one of the preceding claims, wherein the thermal interface material is a rheology controlled thermal interface material that comprises a metal amalgam, a liquid metal, or a low melting alloy.

6. The method of any one of the preceding claims, wherein the thermal interface material comprises a gallium-indium-tin liquid metal alloy including copper and nickel such that the gallium-indium-tin liquid metal alloy includes a ratio of the nickel to the copper within a range from about 1:1 to about 5:1 by weight percent (wt%) and/or by volume percent (vol%).

7. The method of any one of the preceding claims, wherein:
the thermal interface material comprises a rheology controlled thermal interface material; and
the method of forming the three-dimensional thermal joint between the first and second thermal transfer surfaces of the electronic device comprises:
dispensing the rheology controlled thermal interface material between the first and second thermal transfer surfaces; and
allowing the rheology controlled thermal interface material to fill the multiple gaps of different distances between the first and second thermal transfer surfaces so as to form the three dimensionally shaped thermal joint having multiple different heights that correspond to the different distances;
whereby the three-dimensional thermal joint provides a continuous thermal path between the first and second thermal transfer surfaces.

8. The method of any one of the preceding claims, wherein:
the thermal interface material comprises a low melting alloy;
the first thermal transfer surface is defined by a first component of the electronic device;
the second thermal transfer surface is defined by a second component of the electronic device; and
the method includes:
assembling the first component to the second component such that the low melting alloy is between the first and second thermal transfer surfaces;
heating the low melting alloy to a temperature above a typical operating temperature of the electronic device such that the low melting alloy flows into and fills the multiple gaps of different distances between the first and second thermal transfer surfaces of the electronic device; and
allowing the low melting alloy to cool to thereby form the three-dimensional thermal joint filling the multiple gaps of different distances between the first and second thermal transfer surfaces of the electronic device.

9. The method of any one of claims 1 to 7, wherein:
the thermal interface material comprises a liquid metal; and
the method includes:
applying the liquid metal to the first and/or second thermal transfer surface;
allowing the liquid metal to flow into and fill the multiple gaps of different distances between the first and second thermal transfer surfaces; and
allowing the liquid metal to solidify to thereby form the three-dimensional thermal joint filling the multiple gaps of different distances between the first and second thermal transfer surfaces of the electronic device.

10. The method of claim 9, wherein allowing the liquid metal to solidify comprises allowing the liquid metal to solidify at about room temperature whereby the liquid metal does not require heating to form the three-dimensional thermal joint that fills the multiple gaps of different distances between the first and second thermal transfer surfaces of the electronic device.

11. The method of any one of claims 1 to 7, wherein:
the thermal interface material comprises a metal alloy; and
the method includes:
applying the metal alloy to the first and/or second thermal transfer surface;
heating the metal alloy such that molten metal alloy flows into and fills the multiple gaps of different distances between the first and second thermal transfer surfaces; and
allowing the molten metal alloy to cool and re-solidify to thereby form the three-dimensional thermal joint filling the multiple gaps of different distances between the first and second thermal transfer surfaces of the electronic device.

12. The method of claim 11, wherein the metal alloy comprises a gallium-based liquid metal alloy and/or has a melting point of about 160 °C or less.

13. A three-dimensional thermal joint comprising a thermal interface material disposed between first and second thermal transfer surfaces, wherein the first thermal transfer surface is defined by a heat sink, wherein the second thermal transfer surface is defined by a multi-height integrated circuit, wherein the thermal interface material comprises:
(i) low melting alloy having a melting point of 160 °C or less; and
(ii) copper and nickel particles at a total loading range from about 1 weight percent to about 10 weight percent and a nickel-to-copper ratio from about 1:1 to about 5:1;
wherein the thermal interface material forms a stable suspension of the particles; and
wherein the three-dimensional thermal joint formed by the thermal interface material is three-dimensionally shaped with multiple different heights as determined by multiple gaps being filled by the rheology controlled thermal interface material between the heat sink and the multi-height integrated circuit, whereby heat is able to flow through the three-dimensional thermal joint from the multi-height integrated circuit to the heat sink during operation of the electronic device whereby temperature of the multi-height integrated circuit is reduced.

14. The three-dimensional thermal joint of claim 13, wherein the multi-height integrated circuit comprises a 2.5D processor, a 3D processor, or a chiplet segmented processor.

15. The three-dimensional thermal joint according to claim 13 or 14, wherein the thermal interface material is a rheology controlled thermal interface material that comprises a metal amalgam, a liquid metal, or a low melting alloy.
